# EUROPÄISCHE PATENTSCHRIFT

(11) **EP 1 903 321 B1**
(45) Veröffentlichungstag und Bekanntmachung des Hinweises auf die Patenterteilung: **16.02.2011**
(21) Anmeldenummer: 06019996.5
(22) Anmeldetag: 25.09.2006
(51) Int. Cl.: G01L 19/06, G01L 9/00

(54) **Halbleiterbauelement**
Semiconductor device
Dispositif semi-conducteur

(43) Veröffentlichungstag der Anmeldung: 26.03.2008
(73) Patentinhaber: Grundfos Management a/s, 8850 Bjerringbro (DK)
(72) Erfinder: Eriksen, Gert Friis, 2670 Greve (DK); de Reus, Roger, 2860 Søborg (DK); Christensen, Carsten, 2880 Bagsværd (DK)
(74) Vertreter: Vollmann, Heiko

(56) Entgegenhaltungen:
- EP-A- 1 217 095
- EP-A1- 0 736 757
- EP-A2- 0 801 150
- DE-A1- 19 842 105

## Beschreibung

Die Erfindung betrifft ein Halbleiterbauelement für einen Sensor, insbesondere für einen Druck- oder Differenzdrucksensor mit den im Oberbegriff des Anspruchs 1 angegebenen Merkmalen.

Derartige Halbleiterbauelemente, insbesondere zum Einsatz als Druck- oder Differenzdrucksensor sind beispielsweise aus DE 297 24 622 U1 bekannt. Sie bestehen aus einem Halbleitersubstrat, das in dem Bereich, welcher den späteren Membranbereich des Sensors bilden soll, ausgedünnt ausgebildet ist. In diesem Bereich sind auch die eigentlichen Messelemente in Form von Widerständen ausgebildet die typischer Weise zu einer Messbrücke angeordnet sind und im späteren Einsatz aufgrund der Membrandehnung ihrer Widerstandseigenschaften ändern, was wiederum als Maß für den anstehenden Druck zur elektronischen Auswertung herangezogen wird. Das Siliziumsubstrat sowie die darin ausgebildeten Messelemente sind an der Ober- bzw. Unterseite des Substrats jeweils mit einer isolierenden Schicht, typischer Weise einer Oxidschicht versehen, die wiederum mit einer korrosionsfesten Metallschicht, beispielsweise einer Chromtantalschicht überzogen ist. Diese Metallschicht erstreckt sich bei bekannten Bauelementen zu beiden Seiten bis zum Rand und ist lediglich im Bereich der Anschlusskontakte unterbrochen. Sie ist amorph ausgebildet und schützt das Halbleiterbauelement vor einem Kontakt mit dem Medium dessen. Druck gemessen wird. Diese schützende Metallschicht ist so dünn, dass sie die druckbedingte Bewegung der Membran praktisch nicht behindert andererseits aber einen zuverlässigen Schutz bildet.

Grundsätzlich hat sich ein so ausgebildetes Halbleiterbauelement bewährt. Es kommt jedoch vor, dass bei ungünstigen Prozessparametern die Metallschicht nicht vollständig auf dem Hoibteitertiauetement haftet, was nachteilig ist. Darüber hinaus kann es durch Verunreinigungen oder Prozessinstabilitäten dazu kommen, dass die Metallschicht in dem relevanten Bereich nicht homogen ist oder Fehlstellen aufweist, dies kann früher oder später zum Defekt eines solchen. Halbleiterbauelements führen. Weiterhin hat sich gezeigt, dass insbesondere dann, wenn die Fläche des Halbleiterbauelements nicht völlig glatt ausgebildet ist, Fehlstellen in der Metallschicht besonders häufig dort auftreten, wo Abstufungen oder andere topografische Unebenheiten gegeben sind.

Vor diesem Hintergrund liegt der Erfindung die Aufgabe zugrunde, ein gattungsgemäßes Halbleiterbauelement so auszubilden, dass die vorgenannten Probleme vermindert oder nach Möglichkeit ganz vermieden werden und somit die Die Yield verbessert wird.

Diese Aufgabe wird gemäß der Erfindung durch die in Anspruch 1 angegebenen Merkmale gelöst. Vorteilhafte Ausgestaltungen der Erfindung sind in den Unteransprüchen der nachfolgenden Beschreibung und der Zeichnung angegeben.

Das erfindungs gemäße Halbleiterbauelement ist insbesondere für einen Sensor, beispielsweise für einen Druck- oder Differenzdrucksensor bestimmt, kann jedoch auch für andere Zwecke vorgesehen sein. Es weist ein Halbleitersubstrat auf, in dem ein oder mehrere elektronische Bauelemente wie Widerstände, Transistoren oder dergleichen ausgebildet und verschaltet sind und das zumindest einseitig mit einer elektrisch isolierenden Schicht und einer metallhaltigen amorphen Schutzschicht versehen ist. Gemäß der Erfindung ist die elektrisch isolierende Schicht von mindestens zwei amorphen metallhaltigen Schichten unterschiedlicher chemischer Zusammensetzung überdeckt.

Grundgedanke der vorliegenden Erfindung ist es, das Halbleitersubstrat mit den darin oder darauf ausgebildeten elektronischen Bauelenienten und mit der darüber befindlichen elektrisch isolierenden Schicht nicht nur wie aus dem Stand der Technik bekannt mit einer metallhaltigen amorphen Schutzschicht zu versehen sondern mit mindestens zwei amorphen metallhaltigen Schichten zu versehen, die eine unterschiedliche chemische Zusammensetzung aufweisen.

Diese Überdeckung mit zwei Schichten unterschiedlicher chemischer Zusammensetzung bringt bei geeigneter Wahl der chemischen Zusammensetzung und der Schichtdicken erhebliche Vorteile mit sich, die insbesondere darin liegen, dass der Schutz des Substrats gegenüber dem Stand der Technik deutlich verbessert ist und das in mehrerlei Hinsicht, ohne die Beweglichkeit der Membran und die Wärmeleitfähigkeit zu beeinträchtigen und die Fertigungskosten merklich zu erhöhen. Durch die Anordnung von zwei amorphen Metallschichten kann die Fehlerrate der Halbleiterbauelemente erheblich gesenkt und damit die Die Yield erhöht werden, da eine Fehlstelle in einer der beiden metallhaltigen Schichten typischerweise nicht zum Defekt des Halbleiterbauelements führt, da die darüber oder darunter liegende metallhaltige Schicht weiterhin für den notwendigen Schutz sorgt.

Darüber hinaus kann durch geeignete Wahl der Zusammensetzung der metallhaltigen Schichten die Haftung der Schichten untereinander deutlich verbessert werden. Auch kann durch die Anordnung von:zwei Schichten nicht nur die mechanische Stabilität, insbesondere der Membran erhöht werden, sondern es können auch gezielt mechanische Spannungszustände in diesen Schichten erzeugt werden, um äußere Spannungen zu kompensieren oder bestimmte Spannungszustände bei Belastung der Membran zu vermeiden.

Es hat sich überraschenderweise gezeigt, dass Fehlstellen, wie sie sonst beim topographischen Kanten oder Verunreinigungen auf dem Substrat in der Schutzschicht gelegentlich auftreten, beim Überdecken mit zwei amorphen metallhaltigen Schichten vermieden werden können. Das Aufbringen von zwei dünnen amorphen metallhaltigen Schichten unterschiedlicher chemischer Zusammensetzung ergibt einen wesentlich besseren Schutz als der Auftrag einer einzigen Metallschicht entsprechender Schichtdicke.

Als Metalle für die metallhaltigen Schichten können vorteilhaft Metalle wie Tantal, Titan, Eisen, Chrom, Nickel, Kupfer, Zirconium, Vanadium, Niob, Molybdän, Wolfram, Mangan, Kobalt, Ruthenium, Rhodium, Palladium, Hafnium, Ütrium, Irridium. Osmium. Rhenium, Silber, Gold oder Platin eingesetzt werden.

Eine metallhaltige Schicht im Sinne der Erfindung besteht vorteilhaft aus einem der oben genannten Metalle und einem weiteren gebundenen chemischen Element oder aus einer Legierung von Metallen, wie sie oben angegeben sind. Die oben genannten Metalle können binäre amorphe Metalllegierungen bilden mit einer Kristallisationstemperatur, die größer als 400° Kelvin ist, was für den in Rede stehenden Einsatz besonders günstig ist.

Ein besonders guter Verbund der Schichten untereinander kann gemäß einer vorteilhaften Weiterbildung der Erfindung dadurch erreicht werden, dass die Zusammensetzung der metallhaltigen Schichten so gewählt wird, dass mindestens ein chemisches Element benachbarter Schichten übereinstimmt. Wenn das Substrat, was zum Stand der Technik zählt, mit einer isolierenden Schicht in Form einer Oxidschicht überzogen ist, dann kann eine besonders gute Haftung der darauf liegenden metallhaltigen Schicht dann erzielt werden, wenn auch diese metallhaltige Schicht eine Sauerstoffverbindung, also auch eine Oxidschicht ist. Besonders vorteilhaft wird die isolierende Oxidschicht durch eine amorphe Tantaloxidschicht überdeckt, die dann ihrerseits von einer amorphen Chromtantalschicht überdeckt ist. Auf diese Weise wird eine gute Haftung zwischen der Oxidschicht und der Tanfaloxidschicht einerseits sowie der Tantaloxidschicht und der Chromtantolschicht andererseits erzielt. Sowohl die Tantaloxidschicht als auch die Chromtantalschicht bilden dabei jeweils für sich eine Schutzschicht, die für das an der Außenseite des Halbleiterbauelements anstehende Medium, z. B. Wasser, undurchlüssig ist und darüber hinaus korrosionsbeständig ist.

Wenn das Halbleiterbauelement aus einem Halbleitersubstrat aus Silizium aufgebaut ist, dann ist zweckmäßigerweise die isolierende Schicht aus Siliziumoxid gebildet, die Siliziumoxidschicht durch eine Tantaloxidschicht überdeckt, und diese wiederum von einer Chromtantalschicht überdeckt. Die isolierende Schicht kann auf beiden Seiten des Halbleitersubstrats ausgebildefi sein, sie muss jedoch mindestens auf der Seite ausgebildet sein, auf der die Leiterbahnen und Verdrahtungströger sitzen, um eine elektrische Isolierung gegenüber- der benachbarten, metallhaltigen Schicht zu bilden.

Vorteilhaft kann mindestens eine der metallhaltigen Schichten eigenspannungsinduziert ausgebildet sein. Bevorzugt ist dies nicht die oberste sondern die darunter liegende metallhaltige Schutzschicht. Grundsatzlich können sowohl Druckspannungen als auch Zugspannungen in eine oder auch beide der metallhaltigen Schichten induziert werden. Besonders vorteilhaft ist es jedoch wenn Egenspannungen in Form von Druckspannungen in einer Größenordnung von 50 bis 800 MPa induziert werden, da durch eine solche Vorspannung die im Belastungsfalle sonst auftretenden Zugspannungen in der Membran kompensiert werden können, d. h. durch die induzierten Eigenspannungen das Halbleiterelement auch bei Belastung zugspannungsfrei bleibt, zumindest aber die Größe der auftretenden Zugspannungen vermindert wird. Außerdem hat die Druckspannungsbeaufschlagung einen günstigen Effekt auf die Haftungseigenschaften. Beim Einsatz des Halbleiterbauelements als Druck- oder Differenzdrucksensor wird der eigentliche Membranbereich ausgedünnt. Im Membranbereich hat die Druckspannungsiriduzierung in mindestens einer der metallhaltigen Schichten den Vorteil, dass die Membran insgesamt weicher wird, d. h. sich schon bei geringeren Kräften stärker verformt. Dies hat wiederum den positiven Effekt, dass ein damit gebildeter Sensor empfindlicher wird, also einen nach unten hin weiteren Messbereich erschließt.

Besonders vorteilhaft ist es, wenn in beiden aufeinander liegenden metallhaltigen Schichten Druckspannungen induziert sind, wobei dann die in der weiter außen liegenden Schicht induzierten Druckspannungen größer als die in der weiter innen liegenden Schicht sein sollten. Dabei haben sich in der äußeren metallhaltigen Schicht induzierte Druckspannungen zwischen 10 und 800 MPa und in der inneren metallhaltigen Schicht zwischen 10 und 200 MPa als besonders vorteilhaft herausgestellt.

Grundsätzlich ist die Anbringung der amorphen metallhaltigen Schutzschichten nur auf der Seite des Halbleiterelementes erforderlich, welche dem Messmedium, beispielsweise bei der Druckmessung dem Fluid ausgesetzt wird, die andere Seite kann in geeigneter Weise durch das Sensorgehäuse oder andere Maßnahmen geschützt werden. Besonders vorteilhaft ist es jedoch, wenn beide flächigen Seiten des Halbleiterbauelements, also beispielsweise beide Seiten der Membran bei einem für die Druckmessung vorgesehenen Halbleiterbauelement entsprechend ausgestattet sind, dann kann im Übrigen das Bauelement auch als Differenzdrucksensor eingesetzt werden, also von beiden Seiten fluidbeaufschlagt werden. Es wird dann vorteilhaft auch auf der Rückseite mit einer elektrisch isolierenden Schicht und mindestens zwei metallhaltigen amorphen Schichten unterschiedlicher Zusammensetzung versehen, so wie dies weiter oben für die Ausstattung der Vorderseite des Halbleitersubstrats schon beschrieben worden ist. Vorteilhaft werden die auf der Rückseite auf dem Substrat aufgedampften metallhaltigen Schichten in größerer Schichtdicke als auf der Vorderseite aufgebracht.

Das Auftragen der einzelnen Schichten erfolgt in an sich bekannter Weise durch Aufdampfen im PVD-Verfahren (physical vapor deposition). Dann werden nach dem Dotieren des Substrats zunächst an der Vorderseite die Oxidschicht und dann nachfolgend die beiden amorphen metallhaltigen Schutzschichten aufgetragen. Es hat sich gezeigt, dass beim nachfolgenden Auftragen der Schutzschichten auf der Rückseite des Substrats ein deutlich besseres Prozessergebnis erzielt wird, wenn auf die elektrisch isolierende Schicht also typischerweise die Oxidschicht, insbesondere die Siliziumoxidschicht, nicht direkt eine Tantaloxidschicht wie auf der Vorderseite aufgetragen wird, sondern zunächst eine Einmetallschicht, vorteilhaft eineTantalschicht auf die dann nachfolgend eine Tantaloxidschicht aufgetragen wird. Hierdurch können prozessbedingte Unzulänglichkeiten kompensiert werden, so dass z. B. geringe nicht zu vermeidende Verunreinigungen keinen merklichen Einfluss auf die Qualität des späteren Halbleiterelementes haben. Die obere Schutzschicht der Rückseite besteht auch bei dieser Ausführung vorteilhaft aus einer Chromtantalschicht. Das Auftragen einer Einmetallschicht vor dem Auftragen der metallhaltigen amorphen Schichten muss nicht notwendigerweise auf der Rückseite erfolgen, sondern zweckmäßigerweise stets auf der Seite, welche nach Drehen des Wafers durch Aufdampfen bearbeitet wird. Es kann ggf. auch vorteilhaft sein, auf beiden Seiten eine Einmetallschicht vor Auftragen der metallhaltigen amorphen Schichten aufzudampfen.

Zur Ausbildung eines Druck- oder Differenzdrucksensors ist das Substrat im mittleren Bereich zu einer Membran ausgedünnt, in diesen Bereich sind innerhalb des Substrates durch Dotierung piezoresistive Widerstände ausgebildet.

Vorteilhaft sind die Leitungsverbindungen zu und zwischen den elektronischen Bauelementen, also beispielsweise den Widerstanden ebenfalls durch Dotierungen innerhalb des Substrates gebildet, und zwar vorteilhaft durch die Dotierung mit Bor. Dies führt dazu, dass, die Leitungsver bindungen nicht wie beim Stand der Technik auf der Oberfläche des Substrats, sondern innerhalb des Substrats gebildet sind und bündig mit der Oberfläche abschließen, wodurch das Halbleiterelement im Bereich der Membran vollständig glatt ausgebildet sein kann. Dies hat nicht nur mechanische Vorteile sondern ermöglicht darüber hinaus eine bessere Haftung und Aufbringung der amorphen metallhaltigen Schutzschichten und vermeidet somit die sonst gelegentlich auftauchenden Fehlstellen im Bereich topografischer Absätze.

Die metallhaltigen Schichten werden bei der Herstellung des Halbleiterbauelements, die typischer Weise in Form von Wafern erfolgt, so ausgebildet, dass sie mit Abstand zum Rand des Substrats enden. Dadurch dass die metallhaltigen Schichten dort, wo der Wafer später zur Erzeugung der einzelnen Halbleiterelemente mechanisch getrennt wird, ausgespart sind, können beim mechanischen Trennen keine Partikel dieser Schichten in den stirnseitigen Bereich des Halbleiterelements gelangen und dadurch Fehlstellen bilden. Darüber hinaus enden die metallhaltigen Schichten mit Abstand zu den durch Bonden gebildeten elektrischen Anschlüssen auf dem Substrat, damit keine Kurzschlüsse entstehen.

Insbesondere für die Ausbildung eines Druck- oder Differenzdrucksensors aber auch für andere Sensoren ist es vorteilhaft, die Tantaloxidschicht oder die Tantaloxidschichten wenn diese beidseitig vorgesehen sind, in einer Dicke zwischen 200 und 800 nm herzustellen, vorzugsweise sollten diese eine Dicke zwischen 400 und 600 nm aufweisen. Soweit es die Chromtantalschichten angeht, ist eine Schichtdicke zwischen. 400 und 1100 nm zweckmäßig, besonders vorteilhaft sind Schichtdicken zwischen 600 und 850 nm.

Die ggf. insbesondere auf der Rückseite aufzubringende einmetallige Zwischenschicht z.B. aus Tantal weist zweckmäßig eine Dicke von 5 bis 25 nm, vorteilhaft zwischen 8 und 18 nm auf.

Vorteilhaft ist das Halbleitersubstrat im Randbereich des zu der Membran ausgedünnten Bereichs zum übrigen Substrat hin gerundet ausgebildet. Diese Ausbildung hat den Vorteil, dass die Haftung der aufgedampften Schichten in diesem Bereich verbessert wird und insbesondere in diesem Bereich möglicherweise auftretende Fehlstellen vermieden werden.

Das vorbeschriebene Halbleiterbauelement ist besonders vorteilhaft für einen Druck- oder Differenzdrucksensor einsetzbar, die Erfindung beschränkt sich jedoch nicht hierauf, es kann auch für andere Sensoren oder sonstige Anwendungen eingesetzt werden.

Die Erfindung ist nachfolgend anhand eines in der Zeichnung dargestellten Ausführungsbeispiels erläutert. Es zeigen
- Fig. 1: in stark vereinfachter Darstellung ein Halbleiterbauelement in Seitenansicht
- Fig. 2: eine Draufsicht des Halbleiterbauelements gemäß Fig.,1,
- Fig. 3: in vergrößerter Darstellung einen Längsschnitt durch einen Abschnitt des Halbleiterbauelements und
- Fig. 4: in weiter vergrößerter Darstellung einen Längsschnitt eines anderen Abschnitts des Halbleiterbauelements.

Das anhand der Figuren dargestellte Halbleiterbauelement ist für einen Sensor in Form eines Druck- oder Differenzdrucksensors vorgesehen. Es besteht aus einem Halbleitersubstrat 1 aus Silizium, das in einem mittleren Bereich zu einer Membran 2 ausgedünnt ist. Im Bereich der Membran 2 sind Halbleiterbauelemente in Form von Widerständen 3 durch Dotieren innerhalb des Substrats 1 ausgebildet. Die Widerstände 3 sind über Leiterbahnen 4 in an sich bekannter Weise zu einer Brückenschaltung verbunden. Die Leiterbahnen 4 sind durch Dotieren mit Bor ebenfalls innerhalb des Halbleitersubstrats 1 ausgebildet und zu Verdrahtungsträgern 5 geführt, so genannten Bondpads, die elektrisch mit den Leiterbahnen 4 und mechanisch mit dem Halbleitersubstrat 1 verbunden sind und die elektrischen Anschlüsse des Halbleiterbauelements bilden, an denen später durch Bonden die elektrische Verdrahtung erfolgt.

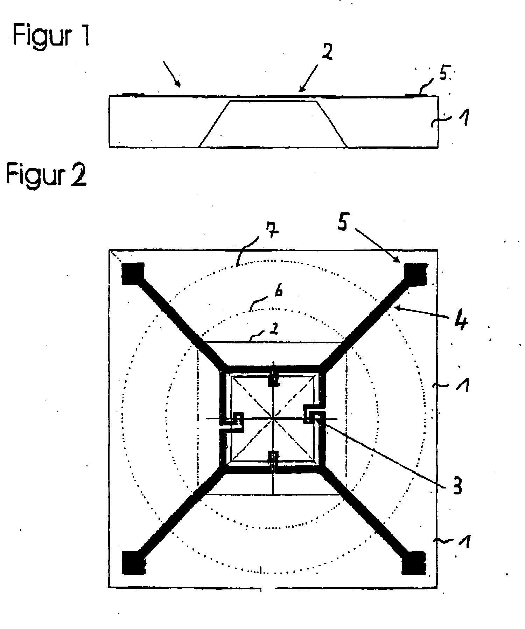

Ein derartiges Halbleiterbauelement, wie es anhand der Fig. 1 und 2 schematisch dargestellt ist, wird in dem in Fig. 2 durch die punktierten Linien 6 und 7 begrenzten Bereich, welcher außerhalb der Membran 2 sowie neben den Verdrahtungsträgern 5 liegt, eingespannt und abgedichtet, derart, dass der Membranbereich vom Medium, dessen Druck oder Differenzdruck zu erfassen ist, ein- oder beidseitig- beaufschlagt werden kann, ohne dass die Verdrahtungsträger 5 mit dem Medium in Kontakt kommen.

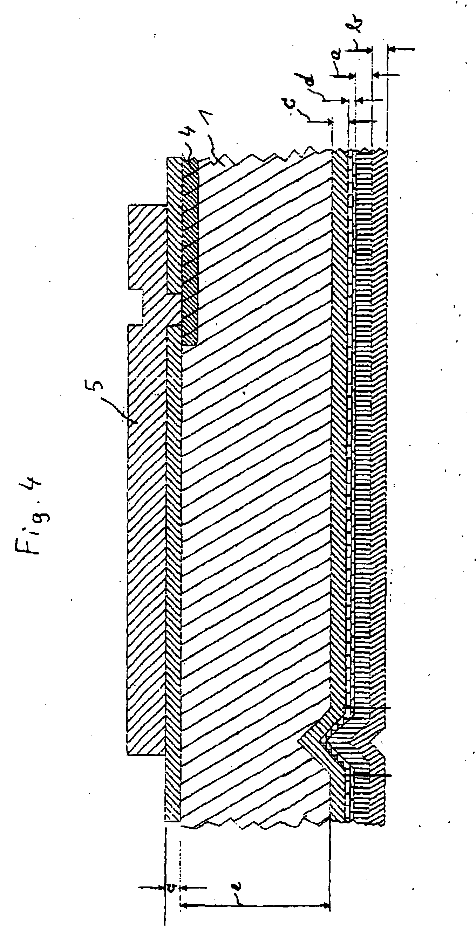

Um den mit dem Medium in Kontakt kommenden Bereich des Halbleitersubstrats 1, insbesondere die Membran 2 vor Korrosion und anderen durch das Medium ausgelösten, unerwünschten Einflüssen zu schützen, sind metallhaltige Schutzschichten 8 und 9 zu beiden Seiten vorgesehen. Um eine elektrische Isolierung zwischen den Schutzschichten und dem Halbleitersubstrat 1 zu bilden, ist das Substrat 1 beidseitig mit einer Siliziumoxidschicht 10 versehen, die sich zu beiden Seiten flächig über das Halbleitersubstrat 1 erstreckt und lediglich, wie aus Fig. 4 ersichtlich ist, im Bereich der elektrischen Verbindung des Verdrahtungsträgers 5 mit dem innerhalb des Halbleitersubstrats 1 liegenden bordotierten Bereichs 4 unterbrochen ist. Diese beidseitig aufgebrachten Siliziumoxid schichten 10 weisen an der Vorderseite (in den Figuren 1, 3 und 4 ist dies die Oberseite), also dort wo auch die Verdrahtungsträger 5 angebracht sind, eine Dicke c von etwa 500 nm auf wohingegen die Siliziumoxidschicht 10 an der Rück- bzw. Unterseite eine Dicke c von lediglich 350 nm aufweist.

An der Vorderseite ist die Siliziumoxidschicht 10 innerhalb des durch die Linie 7 definierten Bereichs, der bis nahe zum Rand des Halbleitersubstrats 1 heranreicht sowie mit Abstand zu den Verdrahtungsträgern 5 endet, mit einer Schutzschicht in Form einer amorphen Tantaloxidschicht 8 versehen, welche eine Schichtdicke von etwa 500 nm aufweist. Diese Tantaloxidschicht 8 bildet zum einen eine antikorrosive Schutzschicht für den darunter befindlichen Bereich des Halbleitersubstrats 1 sowie darüber hinaus auch eine Haftschicht für die darüber aufgebrachte amorphe Chromtantalschicht 9, welche ebenfalls eine Schutzschicht bildet. Die Schichtdicke b der Chromtantalschicht beträgt etwa 800 nm.

Bei der Fertigung werden in an sich bekannter Weise eine Vielzahl derartiger Halbleiterbauelemente in Form eines Wafers gemeinsam gefertigt, wobei die Schichten aufeinanderfolgend durch Aufdampfen hergestellt werden und nach Fertigstellen aller Schichten der Wafer in Einzelbauelemente mechanisch zerteilt wird. Nach Aufdampfen der Siliziumoxidschichten 10 werden zunächst an der Vorderseite die Tantaloxidschicht 8 sowie nachfolgend die Chromtantalschicht 9 aufgedampft, wonach das Aufdampfen der Schichten auf der Rückseite erfolgt. Da beim Aufdampfen der tantalhaltigen Schichten 8, 9 auf der Vorderseite nicht vollständig sichergestellt werden kann, dass geringe Mengen auch auf der Rückseite abgelagert werden, wird vor dem Aufbringen der Tantaloxidschicht 8 und der Chromtantalschicht 9 auf der Rückseite zunächst auf die Siliziumoxidschicht 10 eine Tantalschicht 11 aufgebracht. Diese Tantalschicht 11 weist eine Schichtdicke d von 15 nm auf, ist also extrem dünn, hierauf werden dann wie an der Vorderseite eine Tantaloxidschicht 8 sowie eine Chromtantalschicht 9 aufgedampft. Auch diese Schichten sind amorph und wie die Schutz schichten auf der Vorderseite nicht bis zum Rand des Substrats 1 geführt, sondern enden mit Abstand dazu.

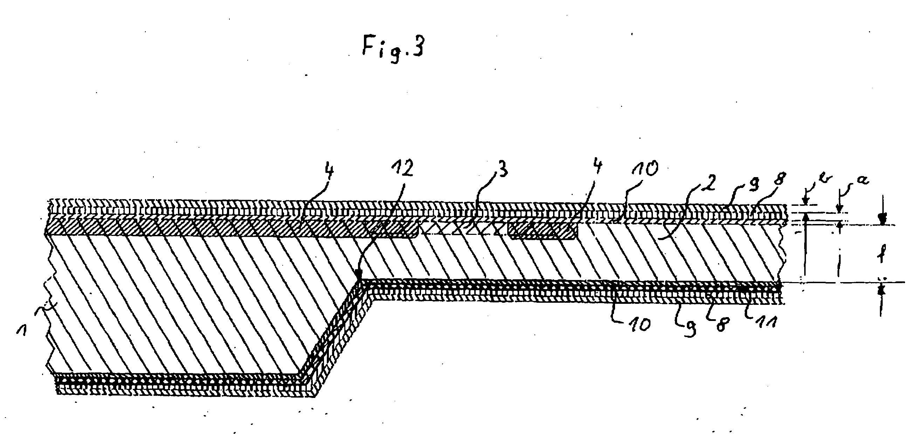

Um die Haftung der Schichten auf der Rückseite des Substrats zu verbessern, weiche durch den ausgedünnten Bereich der Membran 2 gestuft ausgebildet ist, ist der Bereich 12, in welchem die Membran 2 in den übrigen nicht ausgedünnten Bereich des Substrats 1 übergeht, im Übergangsbereich gerundet ausgebildet. Dieser Übergangsbereich ist in Fig. 3 mit 12 gekennzeichnet.

Die amorphen Schutzschichten 8 und 9 können durch, entsprechende Beeinflussung der Parameter beim Aufdampfen eigensponnungsinduziert sein, je nach Anwendungsfall eine oder beide der Schichten 8, 9 sowie an der Vorder- und/oder Rückseite. Bei dem vorstehend beschriebenen aus Silizium gebildeten Halbleitersubstrat 1 sind Egenspannungen von etwa 500 MPa in der äußeren Schicht 9 und von etwa 100 MPa in der inneren Schicht 8 induziert, und zwar in Form von Druckspannungen, damit bei Belastung der Membran 2, wie sie typischerweise durch Beaufschlagung mit einem Medium, dessen Druck- oder Differenzdruck zu ermitteln ist, nicht zugbelastet wird, zumindest die Zugbelastung verringert wird.

Bei dem dargestellten Ausführungsbeispiel beträgt die Dicke des Substrats ca. 600 µm, im ausgedünnten Membranbereich 2 beträgt die Dicke f etwa 20 µm. Die Schichtdicken der metallhaltigen amorphen Schutzschichten 8 und 9 auf der Rückseite des Substrats 1 sind etwa 30 % größer als die der entsprechenden Schichten 8, 9 auf der Vorderseite, wie sie oben im Einzelnen angegeben sind.

### Bezugszeichenliste

- 1: Halbleitersubstrat
- 2: Membran
- 3: Widerstände
- 4: Leiterbahnen
- 5: Verdrahtungsträger
- 6: Linie
- 7: Linie
- 8: Tantaloxidschichten
- 9: Chromtantalschichten
- 10: Siliziumoxidschichten
- 11: Tantalschicht
- 12: gerundeter Bereich von 1, 2

- a: Schichtdicke von 8
- b: Schichtdicke von 9
- c: Schichtdicke von 10
- d: Schichtdicke von 11
- e: Dicke des Substrats
- f: Dicke der Membran

## Patentansprüche

1. Halbleiterbauelement, insbesondere für einen Sensor, beispielsweise einen Druck- oder Differenzdrucksensor, mit einem Halbleitersubstrat (1), in dem ein oder mehrere elektronische Bauelemente (3) ausgebildet und verschaltet sind, das zumindest einseitig mit einer elektrisch isolierenden Schicht (10) und einer metallhaltigen amorphen Schutzschicht (9) versehen ist, **dadurch gekennzeichnet, dass** die elektrisch isolierende Schicht (10) von mindestens zwei amorphen metallhaltigen Schichten (8, 9) unterschiedlicher chemischer Zusammensetzung überdeckt ist.

2. Halbleiterbauelement noch Anspruch 1, **dadurch gekennzeichnet, dass** die Metalle der metallhaltigen Schichten (8, 9) aus Tantal, Titan, Eisen, Chrom, Nickel, Kupfer, Zirconium, Vanadium, Niob, Molybdän, Wolfram, Mangan, Kobalt, Ruthenium, Rhodium. Palladium, Hafnium, Ütrium, Irridium, Osmium, Rhenium, Silber, Gold oder Platin sind.

3. Halbleiterbauelement nach Anspruch 2, **dadurch gekennzeichnet, dass** eine metallhaltige Schicht aus einem der Metalle gemäß Anspruch 2 und einem weiteren gebundenen Element oder aus einer Legierung bestehend aus Metallen, wie sie in Anspruch 2 angegeben sind, besteht.

4. Halbleiterbauelement nach Anspruch 1, **dadurch gekennzeichnet, dass** die Zusammensetzung der metallhaltigen Schichten (8, 9) so gewählt ist, dass mindestens ein chemisches Element benachbarter Schichten übereinstimmt.

5. Halbleiterbauelement nach einem der vorhergehenden Ansprüche, **dadurch gekennzeichnet, dass** auf der isolierenden Schicht (10) eine Tantaloxidschicht (8) angeordnet ist, die ihrerseits von einer chromtantalschicht (9) überdeckt ist.

6. Halbleiterbauelement nach einem der vorhergehenden Ansprüche, **dadurch gekennzeichnet, dass** das Halbleitersubstrat (1) aus Silizium und die isolierende Schicht (10) aus Siliziumoxid gebildet ist.

7. Halbleiterbauelement nach einem der vorhergehenden Ansprüche, **dadurch gekennzeichnet, dass** mindestens eine der metallhaltigen Schichten (8, 9) eigenspannungsinduzierf ausgebildet ist.

8. Halbleiterbauelement nach Anspruch 7, **dadurch gekennzeichnet, dass** die induzierten Egenspannungen Druckspannungen vorzugsweise in einer Größenordnung von 50 bis 800 MPa sind.

9. Halbleiterbauelement nach Anspruch 8, **dadurch gekennzeichnet, dass** in beiden metallhaltigen Schichten (8, 9) Druckspannungen induziert sind, wobei die Druckspannungen in der weiter außen liegenden Schicht (9) größer als die in der weiter innen liegenden Schicht (8) sind.

10. Halbleiterbauelement nach Anspruch 9, **dadurch gekennzeichnet, dass** die induzierten Druckspannungen in der äußeren metallhaltigen Schicht (9) zwischen 10 und 800 MPa und in der inneren metallhaltigen Schicht (8) zwischen 10 und 200 MPa betragen.

11. Halbleiterbauelement nach einem der vorhergehenden Ansprüche, **dadurch gekennzeichnet, dass** das Halbleitersubstrat. (1) auch auf der anderen Seite (Rückseite) gegebenenfalls mit einer elektrisch isolierenden Schicht (10) und mindestens zwei metallhaltigen Schichten (8, 9) unterschiedlicher chemischer Zusammensetzung insbesondere gemäß einem oder mehreren der Ansprüche 2 bis 11 überdeckt ist.

12. Halbleiterbauelement nach einem der vorhergehenden Ansprüche, **dadurch gekennzeichnet, dass** auf mindestens einer Seite des Substrats (1) zwischen der elektrisch isolierenden Schicht (10) und der metallhaltigen Schicht (8) eine nur aus einem Metall bestehende Schicht (11) aufgebraucht ist.

13. Halbleiterbauelement nach einem der vorhergehenden Ansprüche, **dadurch gekennzeichnet, dass** auf der Rückseite des Substrats (1) zwischen der elektrisch isolierenden Schicht (10) und der Tantaloxidschicht (8) eine Tantalschicht (11) aufgebracht ist.

14. Halbleiterbauelement nach einem der vorhergehenden Ansprüche, **dadurch gekennzeichnet, dass** das Substrat (1) im mittleren Bereich zu einer Membran (2) ausgedünnt ist und dass in diesem Bereich piezoresistive Widerstände (3) ausgebildet sind.

15. Halbleiterbauelement nach einem der vorhergehenden Ansprüche, **dadurch gekennzeichnet, dass** die Leitungsverbindungen (4) zu und zwischen den elektronischen Bauelementen (3) durch dotierte, vorzugsweise bordotierte Bereiche des Substrats (1) gebildet sind.

16. Halbleiterbauelement nach einem der vorhergehenden Ansprüche, **dadurch gekennzeichnet, dass** die metallhaltigen Schichten (8, 9) mit Abstand zum Rand des Substrats (1) enden.

17. Halbleiterbauelement nach einem der vorhergehenden Ansprüche, **dadurch gekennzeichnet, dass** die metallhaltigen Schichten (8, 9) mit Abstand zu den durch Bonden gebildeten elektrischen Anschlüsse (5) auf dem Substrat (1) enden.

18. Halbleiterbauelement nach einem der vorhergehenden Ansprüche, **dadurch gekennzeichnet, dass** die Tantaloxidschicht (8) eine Dicke zwischen 200 bis 800 nm, vorzugsweise zwischen 400 bis 600 nm aufweist.

19. Halbleiterbauelement nach einem der vorhergehenden Ansprüche, **dadurch gekennzeichnet, dass** die Chromtantalschicht (9) eine Dicke von 400 bis 1100 nm, vorzugsweise zwischen 600 und 850 nm aufweist.

20. Halbleiterbauelement nach einem der vorhergehenden Ansprüche, **dadurch gekennzeichnet, dass** die aus nur einem Metall bestehende Schicht (11) eine Dicke von 5 bis 25 nm, vorzugsweise zwischen 8 und 18 nm aufweist.

21. Halbleiterbauelement nach einem der vorhergehenden Ansprüche, **dadurch gekennzeichnet, dass** das Halbleitersubstrat (1) im Randbereich des zu der Membran (2) ausgedünnten Bereichs zum übrigen Substrat (1) hin gerundet ausgebildet ist.

## Claims

1. A semiconductor component, in particular for a sensor, for example a pressure sensor or differential pressure sensor, with a semiconductor substrate (1), in which one or more electronic components (3) are formed and connected, which at least on one side is provided with an electrically insulating layer (10) and a metal-containing amorphous protective layer (9), **characterised in that** the electrically insulating layer (10) is covered by at least two amorphous, metal-containing layers (8, 9) of a different chemical composition.

2. A semiconductor component according to claim 1, **characterised in that** the metals of the metal-containing layers (8, 9) are of tantalum, titanium, iron, chromium, nickel, copper, zirconium, vanadium, niobium, molybdenum, wolfram, manganese, cobalt, ruthenium, rhodium, palladium, hafnium, yttrium, iridium, osmium, rhenium, silver, gold or platinum.

3. A semiconductor component according to claim 2, **characterised in that** a metal-containing layer consists of one of the metals according to claim 2 and a further bonded element, or of an alloy consisting of metals as are specified in claim 2.

4. A semiconductor component according to claim 1, **characterised in that** the composition of the metal-containing layers (8, 9) is selected such that at least one chemical element of adjacent layers corresponds.

5. A semiconductor component according to one of the preceding claims, **characterised in that** a tantalum oxide layer (8) is arranged on the insulating layer (10), and this tantalum oxide layer for its part is covered by a chromium-tantalum layer (9).

6. A semiconductor component according to one of the preceding claims, **characterised in that** the semiconductor substrate (1) is formed of silicon, and the insulating layer (10) of silicon oxide.

7. A semiconductor component according to one of the preceding claims, **characterised in that** at least one of the metal-containing layers (8, 9) is designed induced with internal stress.

8. A semiconductor component according to claim 7, **characterised in that** the induced internal stresses are compressive stresses, preferably of a magnitude of 50 to 800 MPa.

9. A semiconductor component according to claim 8, **characterised in that** compressive stresses are induced in both metal-containing layers (8, 9), wherein the compressive stresses in the layer (9) lying further to the outside, are larger than those in the layer (8) lying further to the inside.

10. A semiconductor component according to claim 9, **characterised in that** the induced compressive stresses in the outer metal-containing layer (9) are between 10 and 800 Mpa, and in the inner metal-containing layer (8) are between 10 and 200 Mpa.

11. A semiconductor component according to one of the preceding claim, **characterised in that** the semiconductor substrate (1) also on the other side (rear side), as the case may be, is covered with an electrically insulating layer (10) and at least two metal-containing layers (8, 9) of a different chemical compression, in particular according to one or more of the claims 2 to 11.

12. A semiconductor component according to one of the preceding claims, **characterised in that** a layer (11) consisting of only one metal is deposited on at least one side of the substrate (1) between the electrically insulating layer (10) and the metal-containing layer (8).

13. A semiconductor component according to one of the preceding claims, **characterised in that** a tantalum layer (11) is deposited on the rear side of the substrate (1) between the electrically insulating layer (10) and the tantalum oxide layer (8).

14. A semiconductor component according to one of the preceding claims, **characterised in that** the substrate (1) in the middle region is thinned out into a membrane (2) and that piezoresistive resistors (3) are formed in this region.

15. A semiconductor component according to one of the preceding claims, **characterised in that** the conductor connections (4) to and between the electronic components (3) are formed by doped, preferably boron-doped regions of the substrate (1).

16. A semiconductor component according to one of the preceding claims, **characterised in that** the metal-containing layers (8, 9) end at a distance to the edge of the substrate (1).

17. A semiconductor component according to one of the preceding claims, **characterised in that** the metal-containing layers (8, 9) end at a distance to the electrical connections (5) on the substrate (1), which are formed by bonds.

18. A semiconductor component according to one of the preceding claims, **characterised in that** the tantalum oxide layer (8) has a thickness between 200 to 800 nm, preferably between 400 to 600 nm.

19. A semiconductor component according to one of the preceding claims, **characterised in that** the chromium tantalum layer (9) has a thickness of 400 to 1100 nm, preferably between 600 and 850 nm.

20. A semiconductor component according to one of the preceding claims, **characterised in that** the layer (11) consisting of only one metal has a thickness of 5 to 25 nm, preferably between 8 and 18 nm.

21. A semiconductor component according to one of the preceding claims, **characterised in that** the semiconductor substrate (1) in the edge region of the region thinned out into the membrane (2), is formed in a round manner towards the remaining substrate (1).

## Revendications

1. Dispositif semi-conducteur, en particulier pour un capteur, par exemple un capteur de pression ou capteur de pression différentielle, comprenant un substrat semi-conducteur (1), dans lequel sont réalisés et connectés un ou plusieurs composants électroniques (3), qui est pourvu, au moins sur une face, d'une couche électriquement isolante (10) et d'une couche de protection amorphe métallifère (9), **caractérisé en ce que** la couche électriquement isolante (10) est recouverte d'au moins deux couches métallifères amorphes (8, 9) de composition chimique différente.

2. Dispositif semi-conducteur selon la revendication 1, **caractérisé en ce que** les métaux des couches métallifères (8, 9) sont le tantale, le titane, le fer, le chrome, le nickel, le cuivre, le zirconium, le vanadium, le niobium, le molybdène, le tungstène, le manganèse, le cobalt, le ruthénium, le rhodium, le palladium, l'hafnium, l'yttrium, l'iridium, l'osmium, le rhénium, l'argent, l'or ou le platine.

3. Dispositif semi-conducteur selon la revendication 2, **caractérisé en ce qu'**une couche métallifère est constituée de l'un des métaux selon la revendication 2 et d'un autre élément lié ou d'un alliage constitué de métaux, tels qu'indiqués dans la revendication 2.

4. Dispositif semi-conducteur selon la revendication 1, **caractérisé en ce que** la composition des couches métallifères (8, 9) est choisie de façon qu'au moins un élément chimique de couches adjacentes soit compatible.

5. Dispositif semi-conducteur selon l'une des revendications précédentes, **caractérisé en ce qu'**est disposée sur la couche isolante (10) une couche d'oxyde de tantale (8), elle-même recouverte d'une couche de chrome-tantale (9).

6. Dispositif semi-conducteur selon l'une des revendications précédentes, **caractérisé en ce que** le substrat semi-conducteur (1) est constitué de silicium et la couche isolante (10) d'oxyde de silicium.

7. Dispositif semi-conducteur selon l'une des revendications précédentes, **caractérisé en ce que** des tensions internes sont induites dans au moins l'une des couches métallifères (8, 9).

8. Dispositif semi-conducteur selon la revendication 7, **caractérisé en ce que** les tensions internes induites sont des contraintes de compression, de préférence d'un ordre de grandeur de 50 à 800 Mpa.

9. Dispositif semi-conducteur selon la revendication 8, **caractérisé en ce que** des contraintes de compression sont induites dans les deux couches métallifères (8, 9), les contraintes de compression dans la couche (9) plus extérieure étant plus élevées que celles présentes dans la couche (8) plus intérieure.

10. Dispositif semi-conducteur selon la revendication 9, **caractérisé en ce que** les contraintes de compression induites dans la couche métallifère (9) extérieure sont comprises entre 10 et 800 MPa et dans la couche métallifère (8) intérieure entre 10 et 200 Mpa.

11. Dispositif semi-conducteur selon l'une des revendications précédentes, **caractérisé en ce que** le substrat semi-conducteur (1) est également recouvert sur l'autre face (face arrière), éventuellement, d'une couche électriquement isolante (10) et d'au moins deux couches métallifères (8, 9) de composition chimique différente, en particulier selon l'une ou plusieurs des revendications 2 à 11.

12. Dispositif semi-conducteur selon l'une des revendications précédentes, **caractérisé en ce qu'**est appliquée, sur au moins une face du substrat (1), entre la couche électriquement isolante (10) et la couche métallifère (8), une couche (11) constituée d'un seul métal.

13. Dispositif semi-conducteur selon l'une des revendications précédentes, **caractérisé en ce qu'**est appliquée, sur la face arrière du substrat (1) entre la couche électriquement isolante (10) et la couche d'oxyde de tantale (8), une couche de tantale (11).

14. Dispositif semi-conducteur selon l'une des revendications précédentes, **caractérisé en ce que** le substrat (1) est aminci dans la zone médiane en direction d'une membrane (2) et **en ce que** des résistances piézorésistives (3) sont formées dans cette région.

15. Dispositif semi-conducteur selon l'une des revendications précédentes, **caractérisé en ce que** les connexions de conduction (4) vers et entre les composants électroniques (3) sont formées par des zones du substrat (1) dopées, de préférence dopées au bore.

16. Dispositif semi-conducteur selon l'une des revendications précédentes, **caractérisé en ce que** les couches métallifères (8, 9) se terminent à distance du bord du substrat (1).

17. Dispositif semi-conducteur selon l'une des revendications précédentes, **caractérisé en ce que** les couches métallifères (8, 9) se terminent à distance des raccordements électriques (5) formés par liaison sur le substrat (1).

18. Dispositif semi-conducteur selon l'une des revendications précédentes, **caractérisé en ce que** la couche d'oxyde de tantale (8) présente une épaisseur comprise entre 200 et 800 nm, de préférence entre 400 et 600 nm.

19. Dispositif semi-conducteur selon l'une des revendications précédentes, **caractérisé en ce que** la couche de chrome tantale (9) présente une épaisseur comprise entre 400 et 1100 nm, de préférence entre 600 et 850 nm.

20. Dispositif semi-conducteur selon l'une des revendications précédentes, **caractérisé en ce que** la couche (11) constituée d'un seul métal présente une épaisseur comprise entre 5 et 25 nm, de préférence comprise entre 8 et 18 nm.

21. Dispositif semi-conducteur selon l'une des revendications précédentes, **caractérisé en ce que** le substrat semi-conducteur (1), dans la région de bord de la zone amincie vers la membrane (2), est arrondi jusqu'à l'extrémité du reste de substrat (1).
